(19) Europäisches Patentamt / European Patent Office / Office européen des brevets

(11) **EP 1 652 309 B1**

(12) **EUROPÄISCHE PATENTSCHRIFT**

(45) Veröffentlichungstag und Bekanntmachung des Hinweises auf die Patenterteilung:
**08.10.2008   Patentblatt 2008/41**

(21) Anmeldenummer: **04741227.5**

(22) Anmeldetag: **23.07.2004**

(51) Int Cl.:
**H03M 7/30** (2006.01)

(86) Internationale Anmeldenummer:
**PCT/EP2004/008217**

(87) Internationale Veröffentlichungsnummer:
**WO 2005/013492 (10.02.2005 Gazette 2005/06)**

(54) **VERFAHREN UND VORRICHTUNG ZUR DIGITALISIERUNG SOWIE ZUR DATENKOMPRIMIERUNG ANALOGER SIGNALE**

METHOD AND DEVICE FOR DIGITIZATION AND DATA COMPRESSION OF ANALOG SIGNALS

PROCEDE ET DISPOSITIF POUR NUMERISER DES SIGNAUX ANALOGIQUES ET COMPRIMER LES DONNEES DE CEUX-CI

(84) Benannte Vertragsstaaten:
**AT BE BG CH CY CZ DE DK EE ES FI FR GB GR HU IE IT LI LU MC NL PL PT RO SE SI SK TR**

(30) Priorität: **25.07.2003   DE 10334357**

(43) Veröffentlichungstag der Anmeldung:
**03.05.2006   Patentblatt 2006/18**

(73) Patentinhaber:
- **Sennheiser electronic GmbH & Co. KG**
  **30900 Wedemark (DE)**
- **Friedrich-Alexander-Universität Erlangen-Nürnberg**
  **91054 Erlangen (DE)**

(72) Erfinder:
- **HAUPT, Axel**
  **30855 Langenhagen (DE)**
- **SCHMITT, Volker**
  **30171 Hannover (DE)**
- **HUBER, Johannes**
  **91094 Langensendelbach (DE)**
- **MATSCHKAL, Bernd**
  **90513 Zirndorf (DE)**

(74) Vertreter: **Eisenführ, Günther**
**Eisenführ, Speiser & Partner**
**Patentanwälte Rechtsanwälte**
**Postfach 10 60 78**
**28060 Bremen (DE)**

(56) Entgegenhaltungen:
**EP-A- 0 360 770          US-A- 4 433 604**

- **HUBER J B ET AL: "Spherical logarithmic quantization and its application for DPCM" ITG-FACHBERICHT VDE-VERLAG GERMANY, Nr. 181, Januar 2004 (2004-01), Seiten 349-356, XP009038121 ISSN: 0932-6022**
- **ADOUL J -P ET AL: "Baseband speech coding at 2400 BPS using spherical vector quantization" ICASSP 84. PROCEEDINGS OF THE IEEE INTERNATIONAL CONFERENCE ON ACOUSTICS, SPEECH AND SIGNAL PROCESSING IEEE NEW YORK, NY, USA, 19. März 1984 (1984-03-19), Seiten 1.12/1-4 vol.1, XP002301076**
- **WILSON S G: "Magnitude/phase quantization of independent Gaussian variates" IEEE TRANSACTIONS ON COMMUNICATIONS USA, Bd. COM-28, Nr. 11, November 1980 (1980-11), Seiten 1924-1929, XP002301077 ISSN: 0090-6778**
- **SWASZEK P F: "Uniform spherical coordinate quantization of spherically symmetric sources" IEEE TRANSACTIONS ON COMMUNICATIONS USA, Bd. COM-33, Nr. 6, Juni 1985 (1985-06), Seiten 518-521, XP002301078 ISSN: 0090-6778**

## Beschreibung

Die vorliegende Erfindung betrifft ein Verfahren sowie eine Vorrichtung zur Digitalisierung analoger Signale und ein Verfahren sowie eine Vorrichtung zur Datenkomprimierung analoger Signale.

Viele Bereiche der digitalen Nachrichtenübertragung haben das gemeinsame Ziel, ein zunächst analog vorliegendes Quellensignal (Messwerterfassung, Audiosignalverarbeitung in Studioqualität, usw.) unter Ausnutzung der Vorteile der digitalen Übertragung zu einem Empfänger zu transportieren, um es dort in Form eines analogen Ausgangssignals wiederzugeben. Hierfür muss das Analogsignal zum einen digitalisiert bzw. quantisiert werden, zum anderen muss eine entsprechende Datenkompression erfolgen, um das Signal bei möglichst guter Qualität über ein digitales Übertragungssystem mit begrenzter Rate zu übertragen. Nach einer PCM-Encodierung werden üblicherweise Verfahren zur Datenkompression angewendet, die Redundanz innerhalb des Quellensignals sowie Irrelevanz bzgl. spezieller Eigenschaften des Konsumenten des Signals ausnutzen. Die zahlreichen bereits existierenden Verfahren zur Digitalisierung analoger Quellensignale verfolgen teilweise grundsätzlich verschiedene Ansätze, sie alle lassen sich jedoch in zwei Hauptkategorien einteilen:

i) Verfahren, bei denen die rekonstruierte Wellenform die ursprüngliche Wellenform sehr nahe approximiert, d.h. es erfolgt keine Ausnutzung von Irrelevanz. Wir verwenden hier den Begriff "wellenformerhaltend" anstelle des oft angewendeten Begriffs "verlustlos" in Bezug auf die Wellenformcodierung, da die Digitalisierung eines analogen Signals bei einer begrenzten Datenrate prinzipiell nicht "verlustlos" ist (d.h. unendliche Entropie einer kontinuierlichen Zufallsvariable).

ii) Nicht wellenformerhaltende Verfahren. Sie sind beispielsweise im Audiobereich von entscheidender Bedeutung, da hier oftmals nur der subjektive Höreindruck am Empfängerausgang entscheidend ist (z.B. Ausnutzung psychoakustischer Maskierungseffekte). Hier spielen Wellenformveränderungen (Amplituden- und Phasenverzerrungen), die das Signal durch Quantisierung und Komprimierung erfährt, i.d.R. nur eine untergeordnete Rolle. Üblicherweise führt eine Signalverarbeitung unter Ausnutzung von Irrelevanz zu einer rekonstruierten Wellenform, die sich sehr stark von der ursprünglichen Wellenform unterscheidet und zudem oft mit einer großen Signalverzögerung behaftet ist (z.B. aufgrund von Spektraltransformationen oder äquivalenten blockbasierten Methoden). Die Übertragungsqualität eines solchen Verfahrens lässt sich nicht durch einen Störabstand $10 \log_{10}$ (SNR), SNR: Signal to Noise Ratio, im klassischen Sinne messen; sie muss vielmehr durch aufwendige Hörtests mit trainierten Personen ermittelt werden. Für viele Anwendungsbereiche (z.B. in der Messtechnik, Aufzeichnung von Wellenformen für eine weitere Signalverarbeitung zu einem späteren Zeitpunkt, Echtzeit-Signalübertragung unter Anwendung digitaler Modulationsverfahren, die keine nennenswerte Signalverzögerung zulassen z.B. für drahtlose digitale Bühnenmikrophone) sind derartige Signalcodierungsverfahren jedoch gänzlich unbrauchbar.

US-A-4433604 behandelt die Polarkoordinatendarstellung der zweidimensionalen Koeffizienten einer Fouriertransformation.

Der Artikel "Baseband speech coding at 2400 bps using 'spherical vector quantization"', Adoul et al, IEEE ICASSP 1984, beschäftigt sich mit der Darstellung des Residualsignals eines RELP Kodierers. Er offenbart die Darstellung eines Blocks von D>2 aufeinanderfolgenden Abtastwerten eines Signals, der als D-dimensionaler Vektor im Euklidischen Raum angesehen werden kann, durch Radius und Orientierung des Vektors. Zur Quantisierung des Radius' werden differentielle Verfahren wie Delta mod. oder ADPCM vorgeschlagen.

Es ist somit Aufgabe der vorliegenden Erfindung, ein Verfahren und eine Vorrichtung zum Digitalisieren sowie zum Komprimieren analoger Signale mit verbesserter Qualität vorzusehen.

Diese Aufgabe wird durch ein Verfahren zum Digitalisieren analoger Signale gemäß Anspruch 1, durch eine Vorrichtung zum Digitalisieren analoger Signale gemäß Anspruch 12, durch ein Verfahren zum Komprimieren analoger Signale gemäß Anspruch 8 und eine Vorrichtung zum Komprimieren analoger Signale gemäß Anspruch 17 gelöst.

Somit wird ein Verfahren zur Digitalisierung analoger Quellensignale vorgesehen, bei dem eine *D*-dimensionale sphärisch logarithmische Quantisierung der analogen Quellensignale erfolgt.

Gemäß einem Aspekt der vorliegenden Erfindung wird ebenfalls ein Verfahren sowie eine Vorrichtung zum Komprimieren analoger Quellensignale vorgesehen, bei dem eine Digitalisierung analoger Quellensignale gemäß dem oben beschriebenen Verfahren erfolgt und wobei eine differenzielle Pulscodemodulation durchgeführt wird.

Somit wird ein wellenformerhaltendes Verfahren vorgesehen, welches die folgenden Anforderungen erfüllt: a) geringe Datenrate durch Ausnutzung von günstigen Packungseigenschaften mehrdimensionaler Gitter (Vektorquantisierung) sowie Ausnutzung von Abhängigkeiten in der Folge der Abtastwerte aus dem Quellensignal, b) extrem hoher Dynamikbereich, d.h. das SNR ist konstant über einen sehr großen Aussteuerbereich von z.B. 60 dB und mehr bzgl. der Kurzzeitvarianz eines analogen Quellensignals, c) hoher segmentweiser objektiv messbarer Störabstand für kurze Segmente von Abtastwerten, vorzugsweise im Sinne des Verhältnisses von Varianz des Nutzsignals zum mittleren quadratischen Fehler, d) Unempfindlichkeit gegenüber speziellen Signalparametem wie z.B. segmentweise Wahrscheinlichkeitsdichtefunktion usw. und am wichtigsten e) Einführung einer extrem geringen Signalverzögerung in der Größenordnung weniger (bis zu 10) Abtastperioden.

Die Erfindung beruht auf dem Gedanken, ein Verfahren zur hochauflösenden, wellenformerhaltenden Digitalisierung analoger Signale vorzusehen, wobei die übliche skalare logarithmische Quantisierung auf mehrdimensionale Kugelkoordinaten übertragen wird und sich somit die hieraus resultierenden Vorteile wie z.B. ein konstanter Störabstand über einen extrem hohen Dynamikbereich bei einem sehr geringen Verlust in Bezug auf die Rate-Distortion-Theorie ergeben. Um die im Quellensignal vorhandenen statistischen Abhängigkeiten für einen weiteren Störabstandsgewinn ausnutzen zu können, wird die Differentielle Pulscodemodulation (DPCM) mit sphärisch logarithmischer Quantisierung kombiniert. Das resultierende Verfahren erzielt eine wirksame Datenreduktion mit einem hohen Langzeitsowie Kurzzeitstörabstand bei extrem geringer Signalverzögerung.

Weitere Ausgestaltungen der Erfindung sind Gegenstand der Unteransprüche.

Die Erfindung wird nachfolgend unter Bezugnahme auf die beigefügte Zeichnung näher erläutert.

Figur 1    zeigt eine Darstellung der Proportionalität eines Kreisbogensegmentes zum Radius,

Figur 2    zeigt ein Diagramm zur Veranschaulichung der Anzahl von Quantisierungszellen, die einem Radius zugeordnet sind, normalisiert auf die Zellenanzahl pro Absolutbetrag eines Abtastwertes in skalarer Quantisierung,

Figur 3    zeigt einen Graphen zur Veranschaulichung eines Störabstandverlustes bei verschiedenen $A$ - Werten,

Figur 4    zeigt einen Graphen zur Veranschaulichung des Störabstandes gemäß der vorliegenden Erfindung,

Figur 5    zeigt ein Blockschaltbild eines DPCM-Encoder mit Rückwärtsprädiktion gemäß der vorliegenden Erfindung,

Figur 6    zeigt einen Graphen zur Veranschaulichung des Signal-Rauschabstandes gemäß einem weiteren Ausführungsbeispiel der Erfindung, und

Figur 7    zeigt Graphen der Signalpegel und des Signal-Rauschabstandes gemäß dem weiteren Ausführungsbeispiel der Erfindung.

Das Ziel der logarithmischen Quantisierung ist eine hohe Dynamik des Quantisierers, also ein weiter Bereich des mittleren Signalpegels, in welchem das SNR und somit der maximale relative Quantisierungsfehler

$$\frac{\Delta_{q_i}/2}{r_i}$$

konstant ist. Hierbei bezeichnet $\Delta_{qi}$ die Breite des $i$-ten Quantisierungsintervalles und $r_i$ den jeweiligen Rekonstruktionswert. Diese Aufgabe führt zu der logarithmischen Quantisierung z.B. im Sinne des $A$ - Laws gemäß K. Tröndle, R. Weiß. Einführung in die Pulscodemodulation. Oldenbourg Verlag, Munich, 1974. Für den Bereich mittlerer Aussteuerung ergibt sich für $R \gg 1$ folgender Störabstand gemäß N. S. Jayant, P. Noll. Digital Coding of Waveforms. Prentice-Hall, Englewood Cliffs, New Jersey, 1984.

$$10 \log_{10}(\text{SNR}) = R \cdot 6{,}02\text{dB} + 10 \log_{10} \frac{3}{(1 + \ln(A))^2} , \qquad (1)$$

wobei $R$ die mittlere Rate der Quantisierung (bit/Abtastwert) bezeichnet und $A$ den üblichen Parameter der logarithmischen Quantisierung darstellt; d.h. der maximale relative Fehler ist für Abtastwerte mit einem Betrag $> 1/A$ (bezogen auf einen Signalbereich der Quantisierung von -1 bis +1) konstant. Damit wird ab einem mittleren Signalpegel des Quellensignals von

$$-B_1 \ := \ 20 \log_{10}(1/A) \, \text{dB} \qquad (2)$$

ein Störabstand gemäß (1) erreicht. Der Wert $B_1$ charakterisiert damit den Dynamikbereich der logarithmischen Quantisierung. Innerhalb dieses Dynamikbereiches ist der Störabstand zudem gänzlich unabhängig von der Wahrscheinlichkeitsdichtefunktion (WDF) des Quellensignals, so dass das Verfahren universell einsetzbar ist. Allerdings stellt der Term $10\log_{10}(3/(1 + 1n(A))^2$ im Vergleich zu einer gleichmäßigen Quantisierung bei Vollaussteuerung durch ein gleichverteiltes Signal gewissermaßen einen "Störabstands-Verlust" durch Kompandierung dar, der für einen großen Dynamikbereich zu bezahlen ist.

Nachfolgend wird eine Quantisierung in Kugelkoordinaten in D Dimensionen beschriebenen.

Die Sphärisch logarithmische Quantisierung gehört zur Familie der Vektorquantisierungsverfahren (von z.B. R. M. Gray, David L. Neuhoff. Quantization. IEEE Transactions on Information Theory, pp. 2325-2383, Oct. 1998, Manfred Herbert. Lattice-Quantisierung von Sprach- und Sprachmodellsignalen. Ausgewählte Arbeiten über Nachrichtensysteme, Nr. 79, Editor: H.-W. Schüßler, Erlangen 1991). Durch eine kugeldichte Packung in vielen Dimensionen können beträchtliche Störabstandsgewinne bei der Quantisierung erzielt werden, auch wenn keine statistischen Abhängigkeiten innerhalb der Signale ausgenutzt werden können. Bei sphärischer Quantisierung wird ein Vektor $x := (x_1,..., x_D)$ mit $D$ Abtastwerten in kartesischen Koordinaten durch Polarkoordinaten $u := (\varphi_1,...,\varphi_{D-1}, r)$ ausgedrückt. Die $D - 1$ Winkel $\varphi_i$ sowie der Radius r sind durch folgende Gleichungen gegeben (j: imaginäre Einheit, arg $(\cdot)$ : Argumentfunktion, welche den Winkel einer komplexen Zahl im Bogenmaß angibt):

$$\varphi_1 \quad = \quad \arg\left(x_1 + jx_2\right) \quad \in \left[-\pi, +\pi\right) \qquad\qquad (3)$$

$$\varphi_i \quad = \quad \arg\left(\sqrt{\sum_{l=1}^{i} x_l^2} + jx_{i+1}\right) \quad \in \left[-\frac{\pi}{2}, \frac{\pi}{2}\right], \qquad (4)$$

$$i \in \left\{2,...,D-1\right\}.$$

$$r^2 \quad = \quad \sum_{l=1}^{D} x_l^2 \qquad\qquad (5)$$

Die Rekonstruktion der kartesischen Komponenten aus dem Vektor $u$ erfolgt hieraus gemäß

$$x_i \quad = \quad r \cdot b_{i-1} \cdot \sin\left(\varphi_{i-1}\right), \quad i \in \left\{D,...,2\right\} \qquad (6)$$

$$x_1 \quad = \quad r \cdot b_1 \cdot \cos\left(\varphi_1\right) = r \cdot b_0 , \qquad\qquad (7)$$

mit den Radien $b_i$ der "Breitenkreise" der Einheitskugel (Radius 1):

$$b_{D-1} \quad = \quad 1 , \qquad\qquad (8)$$

$$b_i \quad = \quad 1 \cdot \prod_{l=i+1}^{D-1} \cos\left(\varphi_l\right), \quad i \in \left\{D - 2,...,0\right\}. \qquad (9)$$

Damit ist ausgehend von $\varphi_{D-1}$ eine aufwandsgünstige rekursive Darstellung gefunden. Eine effiziente Implementierung von Vor- und Rücktransformation ist mit Hilfe des sog. CORDIC-Algorithmus (welcher in Volder, Jack. The CORDIC Trigonometric Computing Technique. IRE Trans. Electronic Computing, Vol EC-8, pp. 330-334, Sept. 1959 beschrieben ist) mit geringer Komplexität möglich.

Nachfolgend wird die Sphärisch logarithmische Quantisierung beschrieben:

Damit bei der Quantisierung in Polarkoordinaten die Vorteile der logarithmischen Quantisierung, d.h. die Unabhängigkeit des SNR von der WDF des Quellensignals, weiterhin genutzt werden können, wird nun der Betrag (Radius) logarithmisch gemäß den Vorschriften des $A$ -Law quantisiert. Die Winkel $\varphi_i$ werden individuell gleichmäßig quantisiert, jeweils mit Wahl der Quantisierungsintervalle in Abhängigkeit der bereits quantisierten Winkel

$\hat{\varphi}_l, l \in \{i + 1, i + 2, ..., D - 1\}$ höherer Ordnungen, wie sie auch für die Rekonstruktion verwendet werden. Somit wird eine sehr einfache Implementierung der Quantisierung und der Signalrekonstruktion erzielt, wobei durch die iterative Vorgehensweise gemäß (3) bis (9) eine schrittweise Verarbeitung der einzelnen Koordinaten wie im Fall skalarer Quantisierung bewahrt wird.

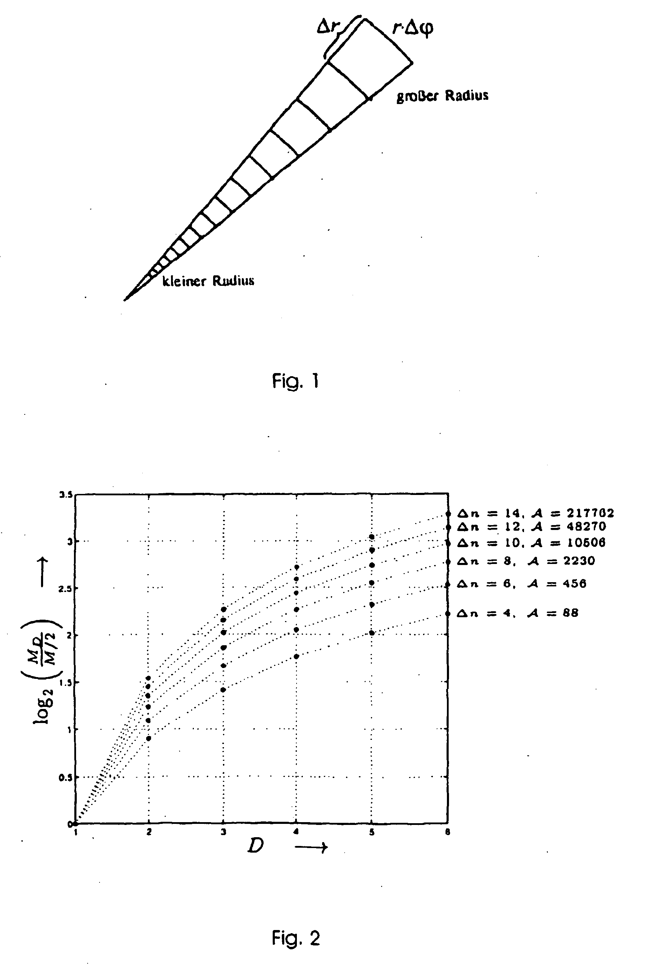

Aufgrund der Proportionalität der Länge eines Kreisbogensegmentes zum Radius sind die Anforderungen an die logarithmische Quantisierung, d.h. die Proportionalität der Größe eines Quantisierungsintervalls zum Signalwert, bereits für gleichmäßige Quantisierung der Winkel erfüllt. Fig. 1 zeigt ein einfaches Beispiel für zwei Dimensionen $D = 2$. Der zweite Term in (1) muss somit nur für eine der insgesamt $D$ Dimensionen bezahlt werden, hierin liegt die wesentliche Ursache für die Gewinne mittels sphärisch logarithmischer Quantisierung.

Um die Implementierung der Quantisierung in Kugelkoordinaten zu vereinfachen, gehen wir von näherungsweise kubischen Quantisierungszellen aus, d.h. die Oberfläche einer $D$-dimensionalen Kugel mit Radius 1 wird durch ein Netz aus $D$ - 1-dimensionalen (Hyper-)Würfeln quantisiert. Wie nachfolgend gezeigt wird, ergibt sich durch diese suboptimale Quantisierung der Kugeloberfläche im Vergleich zu einem optimal dicht gepackten Gitter jedoch im Grenzwert $D \rightarrow \infty$ lediglich ein Verlust von

$$10 \log_{10} \left( \frac{\pi e}{6} \right) = 1{,}53 \cdot dB \,,$$

also ein Ratenverlust von ca. 1/4 bit/Abtastwert, der zugunsten einfacher Implementierbarkeit hingenommen wird.

Im folgenden wird beschrieben, wie die Aufteilung der $M^D$ (d.h. $M := 2^R$) pro Quantisierungsschritt zur Verfügung stehenden Quantisierungsstufen auf die einzelnen Quantisierungsintervalle für den Radius und die Oberfläche der $D$ - dimensionalen Einheits(hyper-)kugel in optimaler Weise vorgenommen wird.

Für den logarithmischen Bereich

$$\frac{r_0}{A} \le r \le r_0$$

der $A$ -Law-Vorschrift gelte wie üblich die folgende Kompressorkennlinie

$$k(r) = r_0 \cdot \left( c \cdot \ln \frac{r}{r_0} + 1 \right) \quad \text{mit} \quad c := \frac{1}{1 + \ln A} \qquad (10)$$

Für deren Ableitung gilt:

$$k'(r) := \frac{dk(r)}{dr} = \frac{c \cdot r_0}{r} \cdot \qquad (11)$$

$A$ bezeichnet den freien Parameter des $A$ -Law und $r_0$ wird als noch näher zu beschreibender Normierungsfaktor für den Radius eingeführt. Mit $M_D$ Quantisierungsintervallen für den Radius ($D$-te Komponente des Vektors $u$) ergibt sich für die Breite der Quantisierungszelle in Richtung des Radius

$$\Delta r(r) \approx \frac{r_0}{M_D \cdot k'(r)} = \frac{1}{M_D \cdot c} \cdot r. \qquad (12)$$

Man beachte, dass $\Delta r(r)$ im betrachteten Bereich unabhängig von $r_0$ ist.

Um bei der Quantisierung in Polarkoordinaten ein ähnliches Übersteuerungsverhalten zu erhalten wie bei kartesischen Koordinaten, wird der Maximalwert $r_0$ für den Radius derart normiert, dass die somit entstehende $D$-dimensionale Kugel das gleiche Volumen besitzt wie ein $D$-dimensionaler Würfel der Kantenlänge 2 (entsprechend einem Quantisierungsbereich $x_i \in [-1;1]$ in jeder Dimension), d. h. $V_{\text{Kugel}} = V_{\text{Würfel}}$:

$$\alpha_D \cdot r_0^D \overset{!}{=} 2^D$$

mit dem Volumen $\alpha_D$ der $D$-dimensionalen Einheitskugel gemäß J. H.Conway and N. J. A. Sloane. Sphere Packings, Lattices, and Groups. Springer-Verlag, 3rd edition.

$$\alpha_D = \frac{\pi^{D/2}}{(D/2)!} . \qquad (13)$$

Damit gilt:

$$r_0 = \frac{2}{\alpha_D^{1/D}} \quad mit \quad r_0 > 1 \quad \forall D \in \mathbb{N} \qquad (14)$$

Um die Bestimmung des resultierenden Störabstandes zu vereinfachen, wird im Folgenden $r = 1$ gesetzt, d.h. es werden diejenigen Quantisierungszellen betrachtet, welche auf der Oberfläche einer Kugel mit Einheitsradius liegen. Dies ist ohne Beschränkung der Allgemeinheit möglich, da das SNR aufgrund der logarithmischen Quantisierung im Bereich

$$\frac{r_0}{A} \le r \le r_0$$

unabhängig vom Radius ist. Für die Breite der Quantisierungszellen erhält man nun

$$\Delta := \frac{1}{M_D \cdot c} . \qquad (15)$$

Durch die bereits angesprochene gleichmäßige Winkelquantisierung wird die Oberfläche der $D$-dimensionalen Einheitskugel in $M_\varphi$ Zellen eingeteilt, welche jeweils die Form von $D - 1$-dimensionalen Würfeln besitzen. Für die Oberfläche dieser $D - 1$-dimensionalen Kugel gilt gemäß J. H. Conway and N. J. A. Sloane. Sphere Packings, Lattices, and Groups. Springer-Verlag, 3rd edition:

$$S = \beta_D \cdot r^{D-1} \quad \text{mit} \quad \beta_D = D \cdot \alpha_D \quad . \qquad (16)$$

Nachfolgend wird die Aufteilung der Quantisierungsstufen auf Radius und Winkel beschrieben.

Für eine faire Aufteilung *der $M^D$* zur Verfügung stehenden Quantisierungszellen auf Radius und Oberfläche der Einheitskugel gelten die folgenden Überlegungen: im Hinblick auf die Approximation durch kubische Quantisierungszellen, d.h. ungefähr gleiche Abmessungen der Quantisierungszellen in allen Dimensionen (Radius und Kreisbogensegmente), muss die Oberfläche der Einheitskugel ($r = 1$) in $M_\varphi$ gleiche *(D - 1)*-dimensionale Würfel mit identischer Kantenlänge $\Delta$ unterteilt werden:

$$S = \beta_D \overset{!}{=} M_\varphi \cdot \Delta^{D-1}. \tag{17}$$

Da $M = 2^R$ Intervalle pro Abtastwert zur Verfügung stehen, muss zusätzlich

$$M_\varphi \cdot M_D \overset{!}{=} M^D \tag{18}$$

gefordert werden.

Mit (15), (17) und (18) erhält man für die Anzahl der für die Quantisierung des Radius zur Verfügung stehenden Quantisierungsintervalle

$$M_D := M \cdot \frac{1}{\beta_D^{1/D}} \frac{1}{c^{(D-1)/D}}. \tag{19}$$

In Fig. 2 sind die Quotienten $M_D$ $I(MI2)$ der Anzahl an Quantisierungszellen, die dem Radius gewidmet sind, normalisiert auf die Zellenanzahl pro Absolutbetrag eines Abtastwertes in skalarer Quantisierung ($D = 1$), gegenüber der Dimensionszahl für mehrere Beispiele des Parameters $A$ der $A$-Law-Kompandierung aufgetragen. Die Werte von $A$ sind derart gewählt, dass die Anwendung der $A$-Law-Kompandierung zu kleinsten Quantisierungsintervallen führt, die um den Faktor $2^{\Delta n}$, $\Delta n \in$ IN kleiner sind, als dies bei gleichmäßiger Quantisierung bei identischer Gesamtintervallzahl der Fall wäre:

$$\Delta r(r \leq 1/A) = 2^{-\Delta n} \cdot \frac{1}{M_D} \text{ , d. h.} \tag{20}$$

$$2^{\Delta n} = \frac{A}{1 + \ln A}. \tag{21}$$

Demzufolge ist die Auflösung für kleine Werte von $r$ um $\Delta n$ bit erhöht.

Fig. 2 zeigt, dass sphärisch logarithmische Quantisierung bis über den Faktor 8 hinaus mehr Intervalle dem Radius zuordnet, als eine skalare Quantisierung mit einer äquivalenten Auflösung im Bereich sehr kleiner Signalwerte. Daher wird ein Gewinn von 3 bit/Abtastwert oder 18 dB für sphärisch logarithmische Quantisierung in diesem Bereich erreicht.

Unter Verwendung von (15) erhält man die Kantenlänge der Quantisierungszellen auf der Oberfläche der Einheitskugel:

$$\Delta = \frac{1}{M} \cdot \left( \frac{\beta_D}{c} \right)^{\frac{1}{D}} . \tag{22}$$

Die Konstante c ist durch den gewählten Dynamikbereich bestimmt, siehe (2) und (10).

Die aktuelle gleichmäßige Quantisierung der Winkelvariablen für gleiche Kreisbogensegmente auf der Einheitskugel erhält man mit Hilfe der rekursiven Gleichungen (8) und (9). Wir haben $M_i$ Intervalle für die Koordinate $\varphi_i$ zur Verfügung:

$$M_{D-1} = \left\lfloor \frac{\pi}{\Delta} \right\rfloor \tag{23}$$

$$M_i\left(\hat{\varphi}_{i+1},...,\hat{\varphi}_{D-1}\right) = \left\lfloor \frac{\pi \cdot \hat{b}_i}{\Delta} \right\rfloor \tag{24}$$

für $\in \{D\text{-}2, D\text{-}3,...,2\}$

$$M_1\left(\hat{\varphi}_2,...,\hat{\varphi}_{D-1}\right) = \left\lfloor \frac{2\pi \cdot \hat{b}_1}{\Delta} \right\rfloor \tag{25}$$

mit $\lfloor x \rfloor \in \text{IN}$ : größte ganze Zahl $\leq x$ mit $x \in \text{IR}^+$ und $\hat{b}_i$ entsprechend (8) und (9) für quantisierte Winkel $\hat{\varphi}_i$.

Es gilt zu beachten, dass die Anzahl $M_i$ der Quantisierungsintervalle in der Dimension $i$ eine Funktion der in den Dimensionen $i + 1,...,D - 1$ ausgewählten Quantisierungszelle ist und daher ausgehend von $M_{D-1}$ iterativ berechnet werden kann. Eine Berechnung im Voraus ist nicht möglich.

Die Zuordnung eines Indexes $N \in \{0,1,...,M^D-1\}$ zu der aktuellen Quantisierungszelle sowie die Rekonstruktion kann durch Anwendung verketteter Lookup-Tabellen, wie sie aus dem Shell Mapping, z.B. gemäß Robert F. H. Fischer. Precoding and Signal Shaping for Digital Transmission, pp. 258-281, John Wiley & Sons, Inc., New York, 2002. ISBN 0471 22410 3 bekannt sind, durchgeführt werden:

Die Zuordnung eines Indexes zum Radius ist unabhängig vom Zellenindex auf der Einheitskugel, somit kann nunmehr das Problem der Indexzuordnung für die Oberfläche der Einheitskugel betrachtet werden.

Die Startnummer des Indexes ist 0, die maximale Endnummer des Indexes ist $M_\varphi - 1$, entsprechend der Anzahl an Quantisierungszellen auf der Oberfläche der Einheitskugel. $M_{D-1}$ ist die Anzahl der Unterkugeln der Dimensionalität $D - 1$ und kann aus (23) berechnet werden. Zugunsten einer schnellen Implementierung wird eine Lookup-Tabelle erster Ordnung mit $M_{D-1}$ Einträgen $N_0,...,N_{M_{D-1}-1}$ verwendet. Hierbei bezeichnet $N_i$ den kleinsten Index aller Zellen, die zu dem $i$-ten Quantisierungsintervall für den Winkel $\hat{\varphi}_{D-1}$ gehören:

$$N_0 = 0 \tag{26}$$

$$N_{i+1} = \sum_{v=0}^{i} M_{D-2}\left(\hat{\varphi}_{D-1} = v \cdot \frac{\pi}{\Delta}\right),$$

$$i \in \left\{0,...,(M_{D-1} - 2)\right\}$$

Somit existieren $N_{i+1}$ - $N_i$ Zellen für einen festgesetzten $i$-ten Wert von $\hat{\varphi}_{D-1}$. Für jedes $N_i$, wird eine Lookup-Tabelle zweiter Ordnung angelegt, welche die Indizes $O_{i,j}$ enthält, die wiederum den kleinsten Index aller Zellen des j-ten Quantisierungsintervalls für den Winkel $\hat{\varphi}_{D-2}$ innerhalb der $D$ - 1-dimensionalen Unterkugel bezeichnen, auf die $N_i$ sich bezieht.

$$O_{i,0} = 0 \qquad\qquad (27)$$

$$O_{i,j+1} = \sum_{v=0}^{j} M_{D-3}\left(\hat{\varphi}_{D-2} = v \cdot \frac{\pi}{\Delta}, \hat{\varphi}_{D-1} = i \cdot \frac{\pi}{\Delta}\right),$$

$$i \in \left\{0,...,\left(M_{D-1} - 1\right)\right\},$$

$$j \in \left\{0,...,\left(M_{D-2}\left(\hat{\varphi}_{D-1} = i \cdot \frac{\pi}{\Delta}\right) - 2\right)\right\}$$

Diese Vorgehensweise führt zu $D$ - 2 Ordnungen von verketteten Lookup-Tabellen, um die $D$ - 1 Winkel zu indizieren (die Lookup-Tabelle der Ordnung $D$ - 1 für den Winkel $\hat{\varphi}_1$ würde aufeinanderfolgende Zellenindizes enthalten und muss deshalb nicht tabellarisiert werden).

Nachfolgend wird das Qluantisierungsgeräusch und der Störabstand näher betrachtet.

Solange eine ausreichend große Anzahl an Quantisierungszellen in $D$ Dimensionen vorliegt, darf die übliche Approximation eines gleichverteilten Quantisierungsfehlers innerhalb dieser kubischen Zellen angewendet werden, wobei jede Zelle durch ihren Mittelpunkt repräsentiert wird. Für die Leistung des Quantisierungsgeräusches gilt näherungsweise

$$\frac{\Delta^2}{12} \cdot D. \qquad\qquad (28)$$

Die sphärisch logarithmische Quantisierung erzwingt $\Delta(r) = \Delta \cdot r$ in allen Dimensionen für $\dfrac{r_0}{A} \le r \le r_0$, daher gilt

$$SNR = \frac{r^2}{\Delta^2 \cdot r^2 \cdot \frac{D}{12}} = F(D) \cdot M^2 \qquad (29)$$

mit

$$F(D) := \frac{12}{D} \cdot \left(\frac{c}{\beta_D}\right)^{\frac{2}{D}} \quad , \qquad (30)$$

siehe auch (22). Wie gewünscht ist das SNR unabhängig von der Varianz des Signals in diesem Bereich.

Durch Einsetzen von (13) und (16) erhält man:

$$F(D) = \frac{12}{\pi} \cdot \frac{1}{D^{\frac{D+2}{D}}} \cdot \left((D/2)!\right)^{2/D} \cdot c^{2/D} . \qquad (31)$$

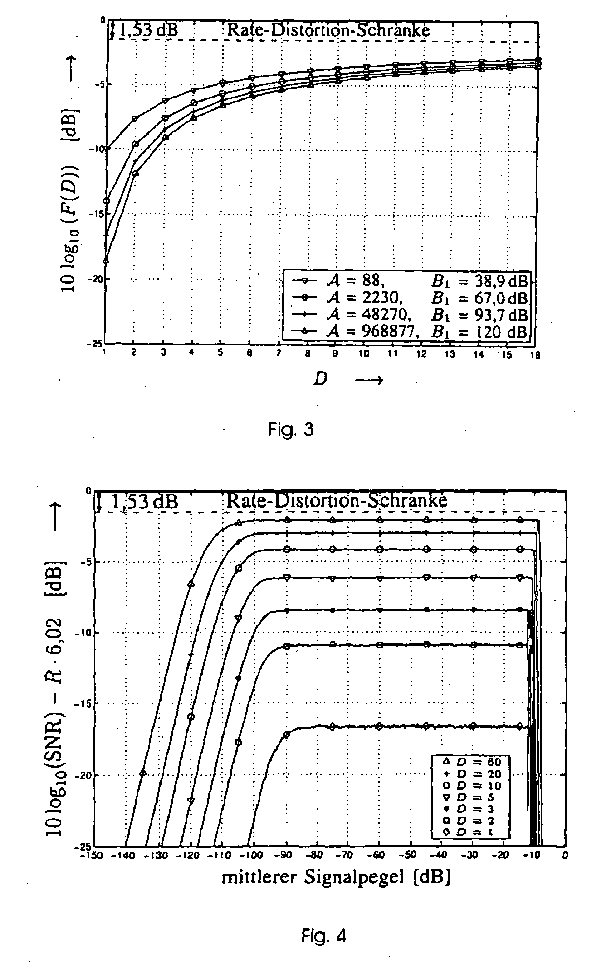

Betrachtet man (29), so kann $F(D)$ als Verlust bezüglich der Rate-Distortion-Schranke für i.i.d. gauß'sche Zufallsvariablen (6 dB-pro-Bit-Regel) interpretiert werden. Dieser Zusammenhang ist in Fig. 3 für verschiedene Werte von $A$ dargestellt.

Mit Hilfe der Stirlingschen Näherung

$$x! \approx \sqrt{2\pi x}\left(\frac{x}{e}\right)^x$$

lässt sich der Grenzwert

$$\lim_{D\to\infty} F(D) = \frac{6}{\pi e} \;\hat{=}\; -1{,}53\,\text{dB} \qquad (32)$$

berechnen, der den Verlust gegenüber der Rate-Distortion-Schranke darstellt, welcher durch die suboptimalen kubischen Quantisierungszellen (gegenüber $(D-1)$-dimensionalen Hyperkugeln für die Quantisierung der Oberfläche einer $D$-dimensionalen Einheitskugel und $D \to \infty$) verursacht wird. Mit anderen Worten: Durch sphärisch logarithmische Quantisierung ist es möglich, den in (1) beschriebenen Verlust infolge der Kompandierung bis auf lediglich 1,53 dB wieder zu kompensieren. Somit ist es durch die Wahl des Parameters $A$ und $D$ theoretisch möglich, einen beliebig großen Dynamikbereich (Bereich konstanten Störabstandes über dem mittleren Signalpegel) zu erzielen, ohne nennenswerte Verluste im maximal erzielbaren Störabstand in Kauf nehmen zu müssen. Der asymptotische SNR-Verlust von 1,53 dB entspricht einem Ratenverlust von 1/4 bit/Abtastwert, der zugunsten einer extremen Reduzierung der Komplexität akzeptiert werden kann.

Da im Sinne der Zielsetzung einer logarithmischen Kompandierung bewusst von keiner Kenntnis einer Wahrscheinlichkeitsdichtefunktion für i.i.d. Quellensignalwerte ausgegangen wird, stellt aber wiederum die Rate-Distortion-Funktion für die gauß'sche Zufallsvariable die untere Schranke für die erreichbare Rate (bzw. Verzerrung) bei gegebener Verzerrung (bzw. Rate) dar (Berger's upper bound der Rate-Distortion-Function gemäß T. Berger. Lossy Source Coding. IEEE Transactions on Information Theory, pp. 2693-2723; Oct. 1998). Somit sind unter den hier gestellten Anforderungen und Einschränkungen über 1,53 dB bzw. 1/4 bit/Abtastwert hinausgehende Verbesserungen ohnehin nicht mehr möglich.

Fig. 4 zeigt als Beispiel den Abstand des Störabstandes von der Rate-Distortion-Schranke $R \cdot 6$dB abhängig vom mittleren Signalpegel (10 $\log_{10}$ (Varianz)) i.i.d. gaußverteilter Zufallsvariablen bei $A = 48270$ für unterschiedliche Dimensionszahlen der sphärisch logarithmischen Quantisierung. Diese Simulationsergebnisse erfüllen exakt die theoretische Analyse gemäß Fig. 3. Auf den ersten Blick scheinen die sehr großen Werte für $A$ , wie sie in den Beispielen der Fig. 3 und 4 sowie in den nachfolgenden Beispielen verwendet werden, unrealistisch und nicht implementierbar. Es gilt hier jedoch zu beachten, dass gewöhnlich wesentlich mehr als $M$ Intervalle mittels (19) für die Quantisierung des Radius $(M_D > M/2)$ verwendet werden, siehe Fig. 2. Selbst für sehr niedrige Raten, z.B. $R = 4$ bit/Abtastwert existieren somit sehr feine Quantisierungsintervalle für den Radius. Darüber hinaus stellt (10) eine invertierbare Funktion für jeden Wert von $A > 1$ dar und ist somit in jedem Fall sehr gut für die Spezfzierung eines bestimmten nichtgleichmäßigen Quantisierers geeignet. Vorzugsweise sollte dieser Ansatz für echte Wellenformcodierung bei extrem geringer Signalverzögerung nicht für Raten unter 3 bit/Abtastwert angewendet werden.

Darüber hinaus wird in Fig. 4 deutlich, dass durch zwei Effekte mit wachsender Dimensionszahl bei konstantem Parameter $A$ der Dynamikbereich stark ansteigt. Zum einen nimmt der Normierungsradius $r_0$ zu, zum anderen wirkt die Begrenzung der logarithmischen Kompression nur auf eine Dimension, auf den Radius, während für $D$ - 1 Dimensionen die Proportionalität der Ausdehnung der Quantisierungszelle zum Signalwert (=Bogenlänge zu Radius bei fixer Winkeldifferenz) auch für kleinste Signalwerte erhalten bleibt. Somit erweitert sich der Dynamikbereich in $D$ Dimensionen näherungsweise auf

$$B_D \quad \approx \quad B_1 + 20\log_{10}(r_0) + 10\log_{10}(D) . \qquad (33)$$

Zudem steigt aufgrund des Mittelungseffektes innerhalb von jeweils $D$ Werten die Übersteuerungsfestigkeit, wodurch eine weitere Vergrößerung des Dynamikbereiches erzielt wird. Im Grenzwert $(D \to \infty)$ ergibt sich ein unendlich großer Dynamikbereich für jeden beliebigen Wert von $A$.

Die strukturbedingte Verzögerung von sphärisch logarithmischer Quantisierung beträgt, wie für jede Vektorquantisierungsmethode, exakt $D$ Abtastwerte. Wie aus Fig. 3 und 4 ersichtlich ist, wird der größte Teil des möglichen Gewinns bereits bei sehr kleinen Werten von $D$ (bis 5) erzielt.

Nachfolgend wird die Kombination von einer sphärischen Quantisierung und DPCM beschrieben.

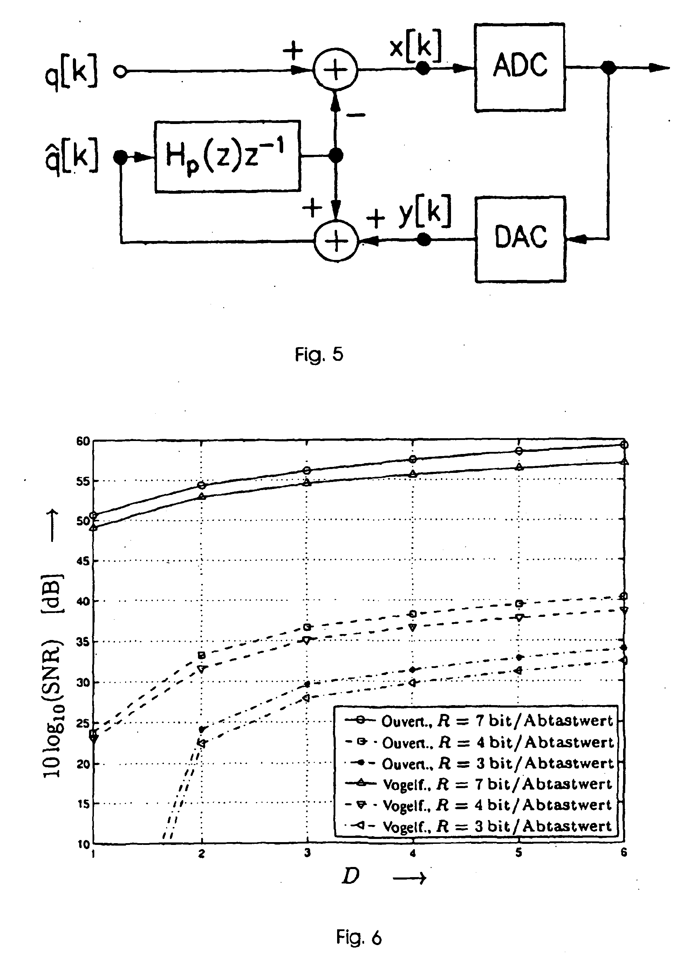

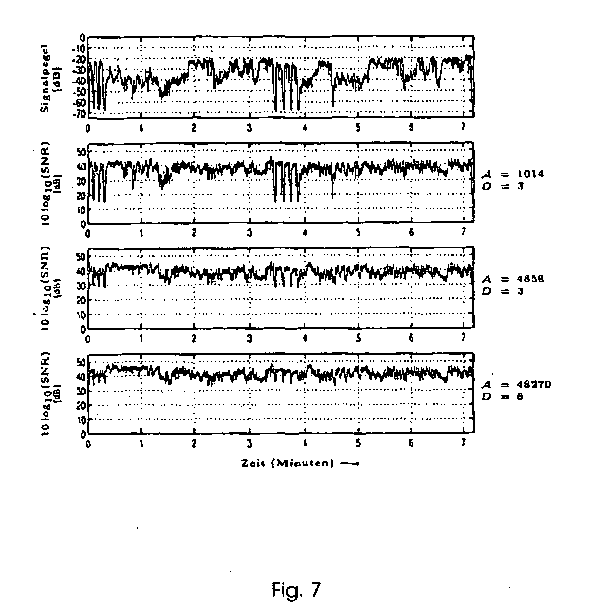

Korrelationen zwischen den Abtastwerten $q[k]$ werden mittels differentieller PCM (DPCM) effizient ausgenutzt, siehe Fig. 5. Ein Prädiktionsfehlersignal $x[k]$ wird durch die Subtraktion von prädizierten Abtastwerten, die mittels eines linearen Prädiktorfilters $H_P(z) \cdot z^{-1}$ aus rekonstruierten Abtastwerten $\hat{q}[k]$ gewonnen werden, erzeugt. Für einen idealen Prädiktor zeigt die Prädiktionsfehlersequenz $x[k]$ ein weißes Leistungsdichtespektrum (PSD) sowie minimale Varianz. Üblicherweise ist dieses Prädiktorfilter adaptiv, um sich an eine nichtstationäre Quelle anzupassen. Vorliegend werden nur Beispiele für ein festes Prädiktorfilter vorgestellt, mit dem Ziel, die Interaktion mit sphärisch logarithmischer Quantisierung möglichst einfach zu beschreiben. Beispielsweise bei Audiosignalen bieten sich bereits sehr kurze, feste Prädiktionsfehlerfilter (entworfen bzgl. eines Kompromiss-Kriteriums) üblicherweise Gewinne von mehr als 18 dB bei einer Abtastfrequenz von 44,1 kHz. Selbst segmentweise Gewinne, gemittelt über 6000 Abtastwerte (0,136s), von weniger als 15 dB lassen sich nur sehr selten beobachten, siehe hierzu Fig. 7 im Vergleich mit Fig. 3. Darüber hinaus ist der Gewinn durch adaptive Prädiktion begrenzt, falls die Signalverzögerung auf einige wenige Abtastwerte beschränkt ist und merkliche Effekte, welche durch Aktualisierungen der Koeffizienten hervorgerufen werden, vermieden werden müssen. Selbstverständlich kann das folgende Material direkt auf adaptive Prädiktion verallgemeinert werden.

Es gilt zu beachten, dass ein SNR-Gewinn, ausgedrückt durch eine Verringerung des mittleren quadratischen Fehlers zwischen originalen und rekonstruierten Abtastwerten, bei Anwendung der sogenannten Rückwärtsprädiktion, wie in Fig. 5 dargestellt, möglich ist.

Bei logarithmischer Quantisierung ist das SNR des Prädiktionsfehlersignals $x[k]$ unabhängig von seiner Varianz oder anders ausgedrückt, die Leistung des Quantisierungsgeräusches ist proportional zur Signalleistung. Somit kann der Prädiktionsgewinn, d.h. der Quotient der Varianzen von $q[k]$ und $x[k]$, direkt in einen SNR-Gewinn überführt werden. Damit ist logarithmische Quantisierung eine gute Wahl für DPCM. Hinzu kommt, dass durch DPCM - verglichen mit PCM - keine weitere systembedingte Signalverzögerung erfolgt, da ein optimales Prädiktionsfehlerfilter für maximalen. Prädiktionsgewinn prinzipiell kausal und strikt minimalphasig ist (vgl. L. Pakula and S. Kay. Simple Proofs of the Minimum Phase Property of the Prediction Error Filter, IEEE Transactions on ASSP, vol. 31, 1983) und daher ohne strukturbedingte Verzögerung invertiert werden kann.

Nachfolgend wird das Gradientenabstiegsverfahren näher beschrieben.

Für die Anwendung von sphärisch logarithmischer Quantisierung auf DPCM mit Rückwärtsprädiktion gilt die gleiche Problematik wie für jede andere Vektorquantisierungsmethode: für die Berechnung des aktuellen Prädiktionsfehlersignalwertes $x[k]$ müssen alle vorausgehenden rekonstruierten Abtastwerte $\hat{q}[k - i]$, $i = 1,2,...$ vorliegen, für einen hohen Prädiktionsgewinn sind insbesondere die unmittelbar vorausgehenden Werte ($i = 1$, $i = 2$) unverzichtbar. Diese Forderung ist leider nicht vereinbar mit der Quantisierung von Blöcken der Länge $D$ Abtastwerte.

Als Lösung für dieses Problem kann jede in der Literatur erwähnte Methode zur Kombination von Vektorquantisierung mit DPCM herangezogen werden. Hier wird eine Methode, in Anlehnung an das Prinzip "analysis by synthesis", verwendet, welches beispielsweise von CELP-Wellenformcodierungsverfahren gemäß N. S. Jayant, P. Noll. Digital Coding of Waveforms. Prentice-Hall, Englewood Cliffs, New Jersey, 1984 bekannt ist und kombinieren diesen Ansatz mit einem diskreten Gradientenabstiegsverfahren.

Um den Widerspruch zwischen DPCM und Vektorquantisierung zu bewältigen, wird die quadratische Euklidische Distanz zwischen Vektoren von Abtastwerten

$$\mathrm{q}[l] = (q[l \cdot D], q[l \cdot D + 1], ..., q[l \cdot D + D - 1]) \qquad (34)$$

und einem entsprechenden Rekonstruktionsvektor $\hat{q}[l]$ minimiert, $l = \lfloor k/D \rfloor$ An dieser Stelle gilt es zu beachten, dass neben der sphärisch logarithmischen Quantisierung die Berechnung des entsprechenden Prädiktionsfehlersignals sowie die Inversion des Prädiktionsfehlerfilters in die Berechnung eines Paares $q, \hat{q}$ mit einbezogen werden muss, wobei auf vorausgehende Rekonstruktionsvektoren $\hat{q}[l - m], m = 1, 2, ...$ zugegriffen wird, diese selbst aber unverändert bleiben. Das Ziel des Algorithmus ist es, diejenige Quantisierungszelle für $x[l]$ zu finden, für welche die Metrik

$$d^2(q, \hat{q}) = \sum_{i=0}^{D-1} (q[D \cdot l + i] - \hat{q}[D \cdot l + i])^2 \qquad (35)$$

minimiert wird. Um einen geeigneten Startwert für den Algorithmus zu finden, schlagen wir vor, mit einer Vorwärtsprädiktion für die aktuellen $D$ Abtastwerte zu beginnen, dies entspricht einer Deaktivierung der Kette aus ADC und DAC in Fig. 5 bzw. der direkten Einspeisung von $q[k], k = l \cdot D, l \cdot D + 1, ..., l \cdot D + D - 1$ in das Prädiktorfilter (in Fig. 5) anstelle von $\hat{q}[k]$. Nun wird der resultierende Vektor $x$ sphärisch logarithmisch quantisiert und dabei ein Startvektor $y$ erzeugt, aus dem wiederum durch gewöhnliche Inversion des Prädiktionsfehlefilters (DPCM-Empfängerstruktur) ein Vektor $\hat{q}$ folgt. Auf diese Weise kann die Metrikberechnung für einen gegebenen quantisierten Vektor $y_i$ erfolgen. Ausgehend von einem aktuellen Rekonstruktionsvektor $y_i$ werden nun die Rekonstruktionsvektoren aller $2D$ nächsten Nachbarn $y_{j[i]}$ in $D$ Dimensionen ermittelt sowie die zugehörigen Metriken gemäß (35) berechnet und miteinander verglichen. Der Vektor mit der geringsten Metrik wird für die nächste Iteration verwendet, d.h. $\arg\min_j d^2(q, \hat{q}_{j[i]})$ erzeugt eine Aktualisierung von $i$, wobei $\hat{q}_i$ dem quantisieren Vektor $y_i$ entspricht und durch Inversion des Prädiktionsfehlerfilters berechnet wird. Existiert kein solcher Vektor, so bricht der Algorithmus ab und gibt den Index des zu übertragenden Vektors $y_i$ aus. Hier ist anzumerken, dass die Nachbarzellen üblicherweise sehr verschiedene Indizes haben und es nicht trivial ist, diese Zellen zu identifizieren. Betrachten wir beispielsweise $D = 3$, so werden die Winkel des Azimuths ($\varphi_1$) bei großen Elevationen ($\varphi_2$ nahe $\pm \pi / 2$) gröber quantisiert, als bei kleinen Elevationen ($\varphi_2$ nahe 0), weil letztere einen größeren Breitenkreis auf der Kugeloberfläche besitzen. Für eine schnelle Implementierung könnten die Indizes der Nachbarzellen in einem ROM für alle Zellen gespeichert werden, solange $M_\varphi$ nicht zu groß ist. Da lineare Prädiktion mit in den Optimierungsprozess einbezogen ist, ist das resultierende SNR manchmal größer als es durch die Addition der Gewinne (in dB) aus sphärisch logarithmischer Quantisierung und Prädiktion (DPCM) vorhergesagt werden kann. Besonders für den Fall kleiner Raten (z.B. $R < 5$ bit/Abtastwert) sind bemerkenswerte SNR-Gewinne beobachtbar, was nachfolgend und in Fig. 6 beschrieben wird. Ein analytisches Ergebnis für das durch diesen Algorithmus erzielbare SNR ist den Autoren derzeit nicht bekannt.

Simulationen zeigen, dass die im Mittel erforderliche Zahl an Iterationen bei ca. 0,25 (pro $D$ Abtastwerte) liegt, und bereits bei einer Beschränkung auf max. 3 Iterationen keine signifikanten Verluste im Vergleich zu einem unbeschränkten Suchraum zu verzeichnen sind, so dass die Suche nach der optimalen Quantisierungszelle für niedrige Dimensionszahlen durchaus in Echtzeit implementierbar ist. Darüber hinaus liefern bereits kleine Werte von D große Gewinne, siehe Fig. 3 und 6.

Empfangsseitig ergibt sich keinerlei Änderung gegenüber üblichen DPCM-Verfahren. An dieser Stelle soll darauf hingewiesen werden, dass die Gesamtverzögerung des Übertragungssystems lediglich $D$ Abtastwerte beträgt und es sich somit für Übertragungen, welche den Anforderungen einer extrem kurzen Verzögerung entsprechen müssen, hervorragend eignet.

Nachfolgend werden Varianten des Verfahrens näher beschrieben.

Zur Beschleunigung der Suche nach der günstigsten Quantisierungszelle, die zu einer minimalen Verzerrung z.B. gemäß (35) führt, sind prinzipiell alle Algorithmen der sog. Lattice-Decodierung bzw. zur Auffindung eines Maximum-Likelihood-Codeworts bei der Kanalcodierung anwendbar, vgl. z.B. Erik Agrell, Thomas Eriksson, Alexander Vardy, Kenneth Zeger. Closest Point Search in Lattices. IEEE Transactions on Information Theory, pp. 2201-2214, Aug. 2002 und die dort angegebenen Referenzen. Dabei ist vorzugsweise eine Transformation dieser Verfahren in Kugelkoordinaten vorzunehmen.

Eine Variante ohne iterative Bestimmung der Quantisierungszelle ist dadurch gegeben, dass anstelle einer Berücksichtigung statistischer Abhängigkeiten innerhalb der aktuell zur Quantisierung anstehenden $D$ Signalwerte durch ein lineares Prädiktionsfilter gemäß Fig. 5 (also DPCM), eine nichtgleichmäßige Quantisierung der Winkelkoordinaten vorgenommen wird. Dabei sind die linearen statistischen Bindungen der aktuell zur Quantisierung anstehenden $D$ Signalwerte zu vergangenen Signalwerten mittels klassischer DPCM mit Rückwärtsprädiktion zu nutzen. Es entsteht also eine Rückwärtsprädiktion, bei der nach $D$ Signalwerten eine Aktualisierung des Prädiktionsfilters um $D$ Schritte erfolgt.

Es wird vorgeschlagen, die logarithmische Quantisierung des Betrags aufrecht zu erhalten, so dass anschließend die Signalpunkte so normiert werden können, dass sie auf einer Kugel mit Radius 1 liegen. Dies erlaubt die analytische Berechnung der Wahrscheinlichkeitsdichtefunktion der Signalpunkte auf der Kugeloberfläche, z.B. bei Annahme eines gauß'schen Signalprozesses aus der Autokorrelationsfunktion des Quellensignals, bzw. eine direkte experimentelle Ermittlung von relativen Häufigkeiten der Signalpunkte auf der Kugeloberfläche.

Für $M >> 1$ lässt sich hieraus z.B. mit Hilfe des Optimierungsansatzes nach [9] eine nichtgleichmäßige kubische Quantisierung der Oberfläche einer Kugel mit Radius 1 bestimmen. Dieser Ansatz besagt, dass im Mittel der Beitrag jeder Quantisierungszelle zum Quantisierungsgeräusch gleich sein soll. Bezeichnet $\Delta_i$ die Kantenlänge einer $(D - 1)$-dimensionalen kubischen Quantisierungszelle sowie $z_i$ den dazugehörigen Mittelpunkt, also den empfangsseitigen Rekonstruktionsvektor mit dem Betrag 1, sowie $f(v); v := (\varphi_1, ..., \varphi_{D-1})$ die Wahrscheinlichkeitsdichtefunktion bzw. relative Häufigkeit von Signalwerten auf der Kugeloberfläche, so soll also näherungsweise erfüllt sein:

$$(D - 1)\frac{\Delta_i^2}{12} \cdot f(z_i) \cdot \Delta_i^{D-1} = const. \qquad (36)$$

mit der Nebenbedingung

$$\sum_{i=1}^{M\varphi} \Delta_i^{D-1} = \beta_D \qquad (37)$$

Hieraus folgt unmittelbar eine $(D - 1)$-dimensionale Kompressor-Funktion $k(v)$, durch welche die ungleichmäßige Quantisierung der Kugeloberfläche eindeutig bestimmt wird. Die ungleichmäßige Quantisierung kann dann beispielsweise wie im eindimensionalen Fall durch eine nichtlineare Verzerrung des Vektors $v$ in einen Vektor $z := k(v)$, anschließende gleichmäßige Quantisierung zum Vektor $z_i$ gemäß Abschnitt III-C und Anwendung der Umkehrfunktion $\hat{v} := k^{-1}(z_i)$ nachfolgend zur Gewinnung des Rekonstruktionsvektors vollzogen werden.

Vorzugsweise ist die resultierende $(D - 1)$-dimensionale Kompressorfunktion durch eine analytisch beschreibbare Funktion anzunähern, oder, analog zu der bei der eindimensionalen Kompression üblichen Darstellung mittels Geradenstücke (z.B. 13-Segment-Kennlinie, siehe [5]), durch $(D - 2)$-dimensionale Teilebenen (mit konstanten partiellen Ableitungen) zu approximieren. Bei einer über dem Raum

$$\left(-\frac{\pi}{2}, \frac{\pi}{2}\right]^{D-2} \times (-\pi, \pi]$$

orthogonalen Rasterung dieser Approximation über den $D - 1$ Winkeln kann eine einfache Auswertbarkeit der Kompressorfunktion erreicht werden.

Zur Simulation von sphärisch logarithmischer Quantisierung in Kombination mit DPCM wurde die Quantisierung der Ouvertüre sowie der Arie "Der Vogelfänger bin ich ja" der Oper "Zauberflöte" von Wolfgang Amadeus Mozart (vgl. Philips Classics Pruductions 1994 (DDD): Mozart: "Der Vogelfänger bin ich ja" (Die Zauberflöte). Polygram Records #442569-2, Track 3) untersucht.

Fig. 6 zeigt Simulationsergebnisse für $R = 3$, $R = 4$ und $R = 7$ bit/Abtastwert bei $A = 102726$, $A = 48270$, $A = 4858$ sowie verschiedenen Dimensionszahlen $D$.

Das Signal wurde zuerst codiert, anschließend decodiert und das SNR durch Vergleich mit dem originalen CD-Signal berechnet. Der Störabstand ist hier jeweils über das gesamte Musikstück gemittelt. Bei den niedrigen Raten steigt das SNR mit *D* im Vergleich zu Fig. 3 noch steiler an, Ursache hierfür ist eine verbesserte Mittelwertbildung. Beim Vergleich der Ergebnisse sind die verschiedenen Werte das Parameters *A* zu beachten. Die Arie "Vogelfänger" ist mit einem mittleren Signalpegel von -32,15 dB auf Audio-CD gespeichert und bietet aufgrund von Signaldynamik und Klangfarben (Vorspiel, Gesang, Rohrflöte) ein anspruchsvolles Beispiel zur Audiosignalcodierung. Da hier ein universelles Prädiktorfilter niedriger Ordnung (*P* = 2) verwendet wurde, können diese Simulationsergebnisse als repräsentativ für eine Vielzahl von Audiosignalen betrachtet werden.

Fig. 6 zeigt die gemessenen Störabstände, gemittelt über das ganze Musikstück. Aus einem Vergleich der Fig. 3 (oder (1)) und Fig. 6 bei *D* = 1, *R* = 7 ist offensichtlich, dass der mittlere Prädiktionsgewinn für diesen einfachen Prädiktor etwa 20 dB bis 23 dB beträgt (Abtastfrequenz: 44,1 kHz!). Bei *R* = 7 wird der Gesamtgewinn bei allen Werten von *D* gut durch die Summe der beiden Einzelgewinne aus sphärisch logarithmischer Quantisierung und DPCM approximiert, wobei dies bei *R* = 4 nur für *D* ≥ 5 gilt. (Selbstverständlich ist (1) nicht anwendbar für beispielsweise *R* = 3 oder *R* = 4 und *D* = 1, *A* = 48270.)

Der mittlere Signalpegel der Ouvertüre liegt bei -27,20 dB; dieses Musikstück ist durch einen sehr großen Dynamikbereich von unterhalb -70 dB bis -17 dB charakterisiert, siehe auch Fig. 7. In Fig. 7 ist der segmentweise Signalpegel sowie die SNRs für das Beispiel Ouvertüre aufgetragen; jedes Segment besteht aus 6000 Abtastwerten und entspricht somit einem Zeitbereich von 0,136 s. Hier wurde sphärisch logarithmische Quantisierung in *D* = 3 Dimensionen mit *A* = 1014 und *A.* = 4858 sowie in *D* = 6 Dimensionen mit *A* = 48270 und dem gleichen Kompromiss-Prädiktor der Ordnung P = 2 wie im ersten Beispiel angewendet. Die obere Kurve zeigt die große Dynamik, hervorgerufen durch die bekannten lauten Töne getrennt durch Generalpausen über mehrere Takte zu Beginn und in der Mitte dieses populären Musikstücks. Die Kurven für *A* = 1014 und *A* = 4858 offenbaren den Vorteil eines wachsenden *A* bzgl. des segmentweisen SNR, man beachte hier insbesondere die Generalpausen. Die untere Kurve in Fig. 7 demonstriert diesen Aspekt für eine weitere Erhöhung von *A* und dem damit verbundenen weiteren SNR-Gewinn von 3 dB aufgrund der höheren Dimensionszahl *D* = 6 (siehe auch Fig. 3). Es gilt zu beachten, dass trotz der niedrigen Rate von *R* = 4 bit/Abtastwert ein 10 $\log_{10}$(SNR) >35dB (bzgl. der originalen CD) selbst in den Generalpausen aufrecht erhalten wird.

Der Wert *A* = 48270 entspricht einer Komprimierung um 12 bits, z.B. für *D* = 1, *R* = 12 wird eine Auflösung von 24 bits für kleine Signalwerte erzielt. Selbstverständlich ist für *D* = 1, *R* = 4 wegen der zu geringen Intervallanzahl eine Auflösung entsprechend 16 bit niemals vorhanden. Aber bei Anwendung sphärisch logarithmischer Quantisierung in 6 Dimensionen ist der extrem große Wert von *A* = 48270 für einen hohen Minimalwert des SNR tatsächlich gut gewählt. Für diesen Fall ist die Auflösung sogar identisch mit derjenigen der originalen CD-Daten für Segmente mit einem Signalpegel von -70 dB und niedriger. Bisher wurde selbst unter trainierten Personen niemand gefunden, der in der Lage war, zuverlässig einen Unterschied zwischen dem quantisierten Signal bei *R* = 4, *D* = 6, *A* = 48270 und dem Originalsignal zu hören.

Vorstehend wurde ein wellenformerhaltendes Digitalisierungsverfahren für analoge Quellensignale gezeigt, das zum einen den Gewinn durch mehrdimensionale Quantisierung mit den Vorteilen der logarithmischen Quantisierung verknüpft und zum anderen in der Lage ist, den objektiven Störabstand durch Addition von Prädiktionsgewinnen zusätzlich zu erhöhen. Abschließend sei angemerkt, dass sich dieses Verfahren neben einem günstigen Austausch von Rate und Verzerrung vor allem durch einen extrem großen Dynamikbereich bei einer gleichzeitig äußerst geringen systembedingten Verzögerung des Signals um nur wenige Abtastintervalle auszeichnet.

**Patentansprüche**

1.  Verfahren zur Verarbeitung digitaler Quellensignale, mit den Schritten:

    - Digitallsierung analoger Quellensignale,
    - Transformation der digitalisierten Quellensignale aus dem Zeitbereich in den sphärischen Bereich, wobei die Transformation eine D-dimensionale Transformation mit D>2 darstellt, und
    - logarithmische Quantislerung des Radius Im sphärischen Bereich.

2.  Verfahren nach Anspruch 1, wobei eine Transformation der Quellensignale in Kugelkoordinaten durchgeführt wird.

3.  Verfahren nach Anspruch 2, wobei eine logarithmische Quantisierung des Betrages in Kugelkoordinaten erfolgt.

4.  Verfahren nach Anspruch 2 oder 3, wobei eine ungleichmäßige Quantisierung der Winkelkoordinaten der Kugelkoordinaten durchgeführt wird.

5.  Verfahren nach Anspruch 1, mit den Schritten:
    Quantisieren der analogen Quellensignale in Polarkoordinaten, wobei der Betrag der Quellensignale in Polarkoordinaten logarithmisch quantisiert wird, und wobei die Quantisierung des Winkels in Polarkoordinaten der analogen Quellensignale in Abhängigkeit der quantisierten Winkel höherer Ordnung erfolgt.

6. Verfahren nach Anspruch 5, wobei
die Quantisierung einer $D$-dimensionalen Kugel mit einem Einheitsradius durch ein Netz aus $D$ - 1-dimensionalen Würfeln erfolgt.

7. Verfahren nach Anspruch 5 oder 6, wobei
diejenigen Quantisierungszellen ausgewählt werden, welche auf der Oberfläche einer Kugel mit Einheitsradius liegen, wobei die Quantisierungszellen $D$ - 1-dimensionale Würfel darstellen.

8. Verfahren zur Komprimierung analoger Signale, mit den Schritten:

Durchführen eines Verfahrens nach einem der Ansprüche 1 bis 7, und
- Durchführen einer differenziellen Pulscodemodulation.

9. Verfahren nach Anspruch 8, mit den Schritten

- Durchführen einer Vorwärtsprädiktion zur Ermittlung eines Startwertes für Abtastwerte der Quantisierung auf der Basis des aktuellen Zustandes eines Prädikatorfilters,
- Rekonstruktion der nachfolgenden $D$ Abtastwerte,
- Durchführen einer $D$-dimensionalen logarithmischen sphärischen Quantisierung der durch die Vorwärtsprädiktion erhaltenen Werte, um eine Startzelle zu bestimmen,
- iteratives Durchlaufen der Prädiktion der differenziellen Pulscodemodulation, um eine Quantisierungszelle mit dem geringsten Quantisierungsfehler zu bestimmen.

10. Verfahren nach Anspruch 8 oder 9, wobei eine Lattice-Decodierung zur Bestimmung einer günstigen Quantisierungszelle durchgeführt wird.

11. Verfahren nach einem der Ansprüche 8 bis 10, wobei eine Rückwärtsprädiktion einer differentiellen Pulscodemodulation durchgeführt wird, wobei nach der Verarbeitung von $D$ Abtastwerten eine Aktualisierung des Prädiktionsfilters um $D$ Schritte erfolgt.

12. Vorrichtung zur Verarbeitung digitaler Quellensignale mit Mitteln zur Digitalisierung analoger Quellensignale, mit Mitteln zur Transformation der digitalisierten Quellensignale aus dem Zeitbereich in den sphärischen Bereich, wobei die Transformation eine D-dimensionale Transformation mit D>2 darstellt, und Mitteln zur logarithmischen Quantisierung des Radius im sphärischen Bereich.

13. Vorrichtung nach Anspruch 12, mit einer Transformationseinrichtung zur Durchführung einer Transformation der analogen Quellensignale in Kugelkoordinaten.

14. Vorrichtung nach Anspruch 12 oder 13, wobei eine logarithmische Quantisierung des Betrages erfolgt.

15. Vorrichtung nach Anspruch 13 oder 14, wobei eine ungleichmäßige Quantisierung der Winkelkoordinaten der sphärischen oder Kugelkoordinaten durchgeführt wird.

16. Vorrichtung zur Komprimierung analoger Signale mit einer Vorrichtung nach einem der Ansprüche 12 bis 15, und einem Encoder für differenzielle Pulscodemodulation.

17. Vorrichtung nach Anspruch 16, mit

- einer Vorwärtsprädiktionseinrichtung zur Ermittlung eines Startwertes für die Abtastwerte der Quantisierung auf der Basis des aktuellen Zustandes eines Prädikatorfilters,
- einer Rekonstruktionseinrichtung zur Rekonstruktion der nachfolgenden $D$ Abtastwerte,
- einer $D$-dimensionalen logarithmischen sphärischen Quantisierungseinrichtung zur Quantisierung der durch die Vorwärtsprädiktion erhaltenen Werte, um eine Startzelle zu bestimmen,

wobei die Prädiktion der differenziellen Pulscodemodulation iterativ durchlaufen wird, um eine Quantisierungszelle mit dem geringsten Quantisierungsfehler zu bestimmen.

18. Vorrichtung nach Anspruch 17, wobei eine Lattice-Decodierungseinrichtung zur Bestimmung einer günstigen Quantisierungszelle verwendet wird.

19. Vorrichtung nach einem der Ansprüche 17 bis 18, wobei eine Rückwärtsprädiktion einer differentiellen Pulscodemodulation durchgeführt wird, wobei nach der Verarbeitung von $D$ Abtastwerten eine Aktualisierung des Prädiktionsfilters um $D$ Schritte erfolgt.

**Claims**

1. Method for processing digital source signals, comprising the steps of:

   - digitizing analogue source signals,
   - transforming the digitized source signals from the time domain into the spherical domain, wherein the transformation is a $D$-dimensional transformation where $D>2$, and
   - logarithmically quantizing the radius in the spherical domain.

2. Method according to claim 1, wherein a transformation of the source signals into spherical coordinates is carried out.

3. Method according to claim 2, wherein a logarithmic quantization of the amount in spherical coordinates is effected.

4. Method according to claim 2 or 3, wherein a non-uniform quantization of the angle coordinates of the spherical coordinates is carried out.

5. Method according to claim 1, comprising the steps of:

   - quantizing the analogue source signals in polar coordinates, wherein the amount of the source signals in polar coordinates is logarithmically quantized, and wherein the quantization of the angle in polar coordinates of the analogue source signals is effected in dependence upon the quantized higher-order angles.

6. Method according to claim 5, wherein the quantization of a $D$-dimensional sphere with a unit radius is effected by a network of $D$- 1-dimensional cubes.

7. Method according to claim 5 or 6, wherein those quantization cells which lie on the surface of a sphere with unit radius are selected, wherein the quantization cells are $D$ - 1-dimensional cubes.

8. Method for the compression of analogue signals, comprising the steps of:

   - carrying out a method according to any one of claims 1 to 7, and
   - carrying out a differential pulse code modulation.

9. Method according to claim 8, comprising the steps of

   - carrying out a forward prediction for determining a starting value for samples of the quantization on the basis of the current state of a predictor filter,
   - reconstructing the subsequent $D$ samples,
   - carrying out a $D$-dimensional logarithmic spherical quantization of the values obtained by the forward prediction in order to determine a starting cell,
   - iteratively running through the prediction of the differential pulse code modulation in order to determine a quantization cell with the smallest quantization error.

10. Method according to claim 8 or 9, wherein a lattice decoding is carried out for determining a favourable quantization cell.

11. Method according to any one of claims 8 to 10, wherein a backward prediction of a differential pulse code modulation is carried out, wherein, after the processing of $D$ samples, an updating of the prediction filter by $D$ steps is effected.

**12.** Apparatus for processing digital source signals having means for digitizing analogue source signals, means for transforming the digitized source signals from the time domain into the spherical domain, wherein the transformation is a $D$-dimensional transformation where $D>2$, and means for logarithmically quantizing the radius in the spherical domain.

**13.** Apparatus according to claim 12, having a transformation device for carrying out a transformation of the analogue source signals into spherical coordinates.

**14.** Apparatus according to claim 12 or 13, wherein a logarithmic quantization of the amount is effected.

**15.** Apparatus according to claim 13 or 14, wherein a non-uniform quantization of the angle coordinates of the spherical coordinates is carried out.

**16.** Apparatus for the compression of analogue signals with an apparatus according to any one of claims 12 to 15 and an encoder for differential pulse code modulation.

**17.** Apparatus according to claim 16, having

- a forward prediction device for determining a starting value for the samples of the quantization on the basis of the current state of a predictor filter,
- a reconstruction device for reconstructing the subsequent $D$ samples,
- a $D$-dimensional logarithmic spherical quantization device for quantizing the values obtained by the forward prediction in order to determine a starting cell, wherein the prediction of the differential pulse code modulation is run through iteratively in order to determine a quantization cell with the smallest quantization error.

**18.** Apparatus according to claim 17, wherein a lattice decoding device is used for determining a favourable quantization cell.

**19.** Apparatus according to any one of claims 17 to 18, wherein a backward prediction of a differential pulse code modulation is carried out, wherein, after the processing of $D$ samples, updating of the prediction filter by $D$ steps is effected.

**Revendications**

**1.** Procédé de traitement de signaux-source numériques, comprenant les étapes suivantes :

- numérisation de signaux-source analogiques du champ temporel au champ sphérique, la transformation représentant une transformation à $D$ dimensions avec $D > 2$, et
- quantification logarithmique du rayon dans le champ sphérique.

**2.** Procédé selon la revendication 1, où est exécutée une transformation des signaux-source en coordonnées de sphère.

**3.** Procédé selon la revendication 2, où est réalisée une quantification logarithmique de la valeur en coordonnées de sphère.

**4.** Procédé selon la revendication 2 ou 3, où est exécutée une quantification irrégulière des coordonnées angulaires des coordonnées de sphère.

**5.** Procédé selon la revendication 1, comprenant les étapes suivantes :

- quantification des signaux-source analogiques en coordonnées polaires, la valeur des signaux-source étant quantifiée logarithmiquement en coordonnées polaires, et la quantification de l'angle en coordonnées polaires des signaux-source analogiques étant réalisée en fonction des angles quantifiés d'ordre supérieur.

**6.** Procédé selon la revendication 5, où la quantification d'une sphère à $D$ dimensions est réalisée avec un rayon unitaire par un réseau de cubes à $D$-1 dimensions.

7. Procédé selon la revendication 5 ou 6, où les cellules de quantification sélectionnées sont celles situées à la surface d'une sphère à rayon unitaire, les cellules de quantification représentant des cubes à $D$-1 dimensions.

8. Procédé de compression de signaux analogiques, comprenant les étapes suivantes :

   - exécution d'un procédé selon l'une des revendications 1 à 7, et
   - exécution d'une modulation d'impulsion codée différentielle.

9. Procédé selon la revendication 8, comprenant les étapes suivantes :

   - exécution d'une prédiction avant pour la détermination d'une valeur initiale pour des échantillons de la quantification sur la base de l'état actuel d'un filtre prédicateur,
   - reconstruction des échantillons $D$ suivants,
   - exécution d'une quantification logarithmique sphérique à $D$ dimensions des valeurs obtenues par la prédiction avant, afin de déterminer une cellule initiale,
   - exécution itérative de la prédiction de la modulation d'impulsion codée différentielle, afin de déterminer une cellule de quantification avec l'erreur de quantification minimale.

10. Procédé selon la revendication 8 ou 9, ou un décodage de treillis est exécuté pour la détermination d'une cellule de quantification avantageuse.

11. Procédé selon l'une des revendications 8 à 10, où une prédiction arrière d'une modulation d'impulsion codée différentielle est exécutée, une actualisation de $D$ pas du filtre de prédiction étant réalisée après traitement de $D$ échantillons.

12. Système de traitement de signaux-source numériques avec des moyens de numérisation de signaux-source analogiques, avec des moyens de transformation des signaux-source numérisés du champ temporel au champ sphérique, la transformation représentant une transformation à $D$ dimensions avec $D > 2$, et des moyens de quantification logarithmique du rayon dans le champ sphérique.

13. Système selon la revendication 12, avec un dispositif de transformation pour l'exécution d'une transformation des signaux-source analogiques en coordonnées de sphère.

14. Système selon la revendication 12 ou 13, où est réalisée une quantification logarithmique de la valeur.

15. Système selon la revendication 13 ou 14, où est exécutée une quantification irrégulière des coordonnées angulaires des coordonnées sphériques ou de sphère.

16. Système de compression de signaux analogiques avec un système selon l'une des revendications 12 à 15, et un encodeur pour la modulation d'impulsion codée différentielle.

17. Système selon la revendication 16, avec

   - un dispositif de prédiction avant pour la détermination d'une valeur initiale pour les échantillons de la quantification sur la base de l'état actuel d'un filtre prédicateur,
   - un dispositif de reconstruction pour la reconstruction des échantillons $D$ suivants,
   - un dispositif de quantification logarithmique sphérique à $D$ dimensions pour la quantification des valeurs obtenues par la prédiction avant, afin de déterminer une cellule initiale,

   la prédiction de la modulation d'impulsion codée différentielle étant itérativement exécutée, afin de déterminer une cellule de quantification avec l'erreur de quantification minimale.

18. Système selon la revendication 17, où un décodage de treillis est utilisé pour la détermination d'une cellule de quantification avantageuse.

19. Système selon l'une des revendications 17 à 18, où une prédiction arrière d'une modulation d'impulsion codée différentielle est exécutée, une actualisation de $D$ pas du filtre de prédiction étant réalisée après traitement de $D$ échantillons.

Fig. 1

Fig. 2

EP 1 652 309 B1

Fig. 3

Fig. 4

20

Fig. 5

Fig. 6

Fig. 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 4433604 A

### In der Beschreibung aufgeführte Nicht-Patentliteratur

- **ADOUL et al.** Baseband speech coding at 2400 bps using 'spherical vector quantization. *IEEE ICASSP,* 1984
- **K. TRÖNDLE ; R. WEIß.** Einführung in die Pulscodemodulation. Oldenbourg Verlag, 1974
- **N. S. JAYANT ; P. NOLL.** Digital Coding of Waveforms. Prentice-Hall, 1984
- **VON Z.B. R. M. GRAY ; DAVID L. NEUHOFF.** Quantization. *IEEE Transactions on Information Theory,* Oktober 1998, 2325-2383
- Lattice-Quantisierung von Sprach- und Sprachmodellsignalen. **MANFRED HERBERT.** Ausgewählte Arbeiten über Nachrichtensysteme. 1991
- **VOLDER ; JACK.** The CORDIC Trigonometric Computing Technique. *IRE Trans. Electronic Computing,* September 1959, vol. EC-8, 330-334
- **J. H. CONWAY ; N. J. A. SLOANE.** Sphere Packings, Lattices, and Groups. Springer-Verlag
- **ROBERT F. H. FISCHER.** Precoding and Signal Shaping for Digital Transmission. John Wiley & Sons, Inc, 2002, 258-281
- **T. BERGER.** Lossy Source Coding. *IEEE Transactions on Information Theory,* Oktober 1998, 2693-2723
- **L. PAKULA ; S. KAY.** Simple Proofs of the Minimum Phase Property of the Prediction Error Filter. *IEEE Transactions on ASSP,* 1983, vol. 31
- **N. S. JAYANT ; P. NOLL.** Digital Coding of Waveforms. Prentice-Hall, 1984
- **ERIK AGRELL ; THOMAS ERIKSSON ; ALEXANDER VARDY ; KENNETH ZEGER.** Closest Point Search in Lattices. *IEEE Transactions on Information Theory,* August 2002, 2201-2214